# EUROPEAN PATENT APPLICATION

(11) **EP 4 718 999 A1**
(43) Date of publication of application: **01.04.2026**
(21) Application number: 25823107.5
(22) Date of filing: 30.06.2025
(51) Int. Cl.: H10F 19/40

(54) **SOLAR PHOTOVOLTAIC MODULE**

(30) Priority: 04.07.2024 CN 202421575511 U
(71) Applicant: Huansheng New Energy (Jiangsu) Co., Ltd., Yixing Wuxi, Jiangsu 214203 (CN)
(72) Inventor: YANG, Qing, Wuxi, Jiangsu 214203 (CN); WANG, Peng, Wuxi, Jiangsu 214203 (CN); MU, Chengwei, Wuxi, Jiangsu 214203 (CN); CHEN, Liangshui, Wuxi, Jiangsu 214203 (CN)
(74) Representative: Cicconetti, Andrea
(86) International application number: PCT/CN2025/106268
(87) International publication number: WO 2026/007933

(57) **Abstract**

The present disclosure provides a solar photovoltaic module, which belongs to the technical field of manufacturing solar photovoltaic module. The solar photovoltaic module comprises a plurality of solar cell strings. Each solar cell string comprises a plurality of sub-cells whose edges are sequentially shingled and electrically connected, and the sub-cells are obtained by cutting an entire solar cell. In an extending direction of the solar cell string, for two adjacent sub-cells, a non-cut edge of a previous sub-cell is located above a cut edge of a subsequent sub-cell, and the non-cut edge of the previous sub-cell is located on a light-receiving side of the photovoltaic module. The photovoltaic module with this specific structure is able to effectively improve the power generation efficiency of the photovoltaic module, and also has advantages such as a short research and development cycle and a low research and development cost.

## Description

### CROSS-REFERENCE TO RELATED APPLICATION

The present disclosure claims the priority to the Chinese patent application with the filling No. 2024215755111 filed with the China National Intellectual Property Administration on July 4, 2024, and entitled "SOLAR PHOTOVOLTAIC MODULE", the contents of which are incorporated herein by reference in entirety.

### TECHNICAL FIELD

The present disclosure relates to the technical field of manufacturing solar photovoltaic module, and in particular, to a solar photovoltaic module.

### BACKGROUND ART

In the prior art, solar cell strings in solar photovoltaic modules (e.g., shingled photovoltaic modules) are usually formed by sequentially shingling multiple sub-cells, where the sub-cells are generally obtained by cutting an entire solar cell. Currently, with the needs of technological development, there is an urgent desire to improve the power generation efficiency of photovoltaic modules. Common improvement measures typically involve optimizing the circuit structure of photovoltaic modules (e.g., adjusting the series-parallel relationship between solar cell strings) or optimizing the structure of solar cells themselves. Although these improvement measures can improve the power generation efficiency of photovoltaic modules to a certain extent, the improvement in power generation efficiency is limited, and there are problems such as long research and development cycles and high research and development costs.

### SUMMARY

The purpose of the present disclosure is to provide a solar photovoltaic module, which is able to effectively improve the power generation efficiency of the photovoltaic module while having advantages such as a short research and development cycle and a low research and development cost.

Embodiments of the present disclosure are implemented as follows.

Embodiments of the present disclosure provide a solar photovoltaic module. The solar photovoltaic module comprises a plurality of solar cell strings. Each solar cell string comprises a plurality of sub-cells whose edges are sequentially shingled and electrically connected, and the sub-cells are obtained by cutting an entire solar cell. In an extending direction of the solar cell string, for two adjacent sub-cells, a non-cut edge of a previous sub-cell is located above a cut edge of a subsequent sub-cell, and the non-cut edge of the previous sub-cell is located on a light-receiving side of the photovoltaic module.

In the above technical solution, in the extending direction of the solar cell string, for two adjacent sub-cells, the non-cut edge of the previous sub-cell is arranged above the cut edge of the subsequent sub-cell, and the non-cut edge is arranged on the light-receiving side of the photovoltaic module. This specific shingling method is able to hide the cut edge which has lower solar energy utilization efficiency on a back of the photovoltaic module, thereby reducing the adverse impact of the existence of the cut edge on the power generation efficiency of the photovoltaic module to a certain extent, and thus improving the power generation efficiency of the photovoltaic module. Moreover, since there is no need to adjust the structure of the solar cell itself or the circuit structure of the photovoltaic module, the solar photovoltaic module with this structure also has advantages such as a short research and development cycle and a low research and development cost.

In some optional implementations, in a single solar cell string, a plurality of sub-cells each have a cut edge and a non-cut edge. In an extending direction of the solar cell string, for any two adjacent sub-cells, a non-cut edge of a previous sub-cell is located above a cut edge of a subsequent sub-cell.

In the above technical solution, the plurality of sub-cells in the same solar cell string each have a cut edge and an opposite non-cut edge. That is, the plurality of sub-cells are all obtained through a specific cutting method of cutting one entire solar cell into two parts. On this basis, for any two adjacent sub-cells, the non-cut edge of the previous sub-cell is arranged above the cut edge of the subsequent sub-cell, so that the cut edges of all the sub-cells (except for a first sub-cell) in the entire photovoltaic module are all located on the back of the photovoltaic module. That is, only the non-cut edges of the sub-cells participate in solar photovoltaic power generation, so that the corresponding photovoltaic module has high power generation efficiency.

In some optional implementations, in a single solar cell string, a sub-cell has either a cut edge and a non-cut edge or two cut edges. In an extending direction of the solar cell string, at least one of a first sub-cell and a last sub-cell of the solar cell string has a cut edge and a non-cut edge.

In the above technical solution, the plurality of sub-cells in the same solar cell string have two different forms, that is, a sub-cell has a cut edge, or a sub-cell has two cut edges. That is, the corresponding plurality of sub-cells are obtained through the cutting methods such as cutting one entire solar cell into three parts, four parts, or five parts. For these specific cutting methods, in the same entire solar cell, except that the sub-cells cut from the two ends of the entire solar cell each have a cut edge and a non-cut edge, all sub-cells cut from other positions each have two cut edges without a non-cut edge. On this basis, in the extending direction of the solar cell string, by arranging at least one of the first sub-cell and the last sub-cell of the solar cell string to have a cut edge and a non-cut edge, the number of cut edges on the light-receiving side of the photovoltaic module is able to be reduced, thereby effectively improving the power generation efficiency of the photovoltaic module.

In some optional implementations, in the extending direction of the solar cell string, the first sub-cell and the last sub-cell of the solar cell string each have a cut edge and a non-cut edge.

In the above technical solution, based on the sub-cells obtained through the cutting methods such as cutting one entire solar cell into three parts, four parts, or five parts, in the extending direction of the solar cell string, both the first sub-cell and the last sub-cell of the solar cell string are arranged to have a cut edge and a non-cut edge. That is, the sub-cells with two cut edges and no non-cut edge are all arranged in an inner area of the corresponding solar cell string, which is able to further reduce the number of cut edges on the light-receiving side of the photovoltaic module, thereby more effectively improving the power generation efficiency of the photovoltaic module.

In some optional implementations, each solar cell string comprises a plurality of solar cell units whose edges are sequentially shingled and electrically connected, and each solar cell unit comprises N sub-cells whose edges are sequentially shingled and electrically connected, where N is a positive integer that is greater than or equal to 3. In at least some of the solar cell units, a first sub-cell and a last sub-cell each have a cut edge and a non-cut edge, and N-2 sub-cells between the first sub-cell and the last sub-cell each have two cut edges.

In the above technical solution, under normal circumstances, in a case where there is no problem of solar cell cutting damage (i.e., in a case where all sub-cells cut from an entire solar cell are able to be used normally), multiple sub-cells obtained by cutting the same entire solar cell are combined into a solar cell unit. Correspondingly, the number of sub-cells in each solar cell unit corresponds to the cutting method (for example, when the cutting method is cutting one entire solar cell into N parts, the number of sub-cells in each solar cell unit is N). Then, the solar cell string may be obtained by sequentially shingling the plurality of solar cell units. On this basis, for the sub-cells obtained through the cutting method of cutting one entire solar cell into N parts, some of the solar cell units are arranged in a specific form, i.e., the first sub-cell and the last sub-cell each have a cut edge, and the N-2 sub-cells in the middle each have two cut edges without a non-cut edge, which is able to reduce the number of cut edges on the light-receiving side of the photovoltaic module, thereby effectively improving the power generation efficiency of the photovoltaic module.

In some optional implementations, each solar cell unit comprises three sub-cells whose edges are sequentially shingled and electrically connected. In the at least some of the solar cell units, the first sub-cell and the last sub-cell each have a cut edge and a non-cut edge, and a sub-cell between the first sub-cell and the last sub-cell has two cut edges.

In the above technical solution, specifically, for the sub-cells obtained through the cutting method of cutting one entire solar cell into three parts, some of the solar cell units are arranged in a specific form, i.e., the first sub-cell and the last sub-cell each have a cut edge and a non-cut edge, and the sub-cell in the middle has two cut edges without a non-cut edge, which is able to reduce the number of cut edges on the light-receiving side of the photovoltaic module, thereby effectively improving the power generation efficiency of the photovoltaic module.

In some optional implementations, in each solar cell unit, a first sub-cell and a last sub-cell each have a cut edge and a non-cut edge, and a sub-cell between the first sub-cell and the last sub-cell has two cut edges.

In the above technical solution, for the sub-cells obtained through the cutting method of cutting one entire solar cell into three parts, all the solar cell units are arranged such that the first sub-cell and the last sub-cell each have a cut edge and a non-cut edge, and the sub-cell in the middle has two cut edges without a non-cut edge. This shingling method is able to further reduce the number of cut edges on the light-receiving side of the photovoltaic module, thereby more effectively improving the power generation efficiency of the photovoltaic module.

In some optional implementations, the solar photovoltaic module is a monofacial photovoltaic module or a bifacial photovoltaic module.

In the above technical solution, there are many specific applicable types of the solar photovoltaic module, which can provide many implementable solutions, thereby facilitating the promotion and application of the technical solutions provided in the embodiments of the present disclosure.

In some optional implementations, in each solar cell string, in the extending direction of the solar cell string, a dimension of an overlapping area of any two adjacent sub-cells is in a range of 0.1 mm to 1 mm.

In the above technical solution, the overlapping area of any two adjacent sub-cells is limited to a specific range, which is able to well balance the manufacturing cost and power generation efficiency (generally, a smaller overlapping area leads to a higher manufacturing cost. However, if the overlapping area is too large, the light-receiving area is decreased, which in turn reduces the power generation efficiency).

In some optional implementations, in the extending direction of the solar cell string, any two adjacent sub-cells are electrically connected through a solder ribbon. In the extending direction of the solar cell string, the solder ribbon comprises an overlapping-area solder ribbon located in an overlapping area and a non-overlapping-area solder ribbon located outside the overlapping area. A thickness of the overlapping-area solder ribbon is less than a thickness of the non-overlapping-area solder ribbon, and a width of the overlapping-area solder ribbon is greater than a width of the non-overlapping-area solder ribbon.

In the above technical solution, any two adjacent sub-cells are electrically connected through the solder ribbon, which has advantages such as firm connection, good electrical conductivity, and ease of industrial manufacturing. In addition, the thickness of the overlapping-area solder ribbon is set to be less than the thickness of the non-overlapping-area solder ribbon, and the width of the overlapping-area solder ribbon is set to be greater than the width of the non-overlapping-area solder ribbon, i.e., the overlapping-area solder ribbon is thinned and widened, which is conducive to improving the electrical conductivity while improving the mechanical strength after connection.

### BRIEF DESCRIPTION OF DRAWINGS

To illustrate the specific implementations of the present disclosure or the technical solutions in the prior art more clearly, the drawings that need to be used in the description of the specific implementations or the prior art will be briefly introduced below. Obviously, the drawings in the following description are some implementations of the present disclosure, and those of ordinary skill in the art may also obtain other drawings based on these drawings without creative efforts.
FIG. 1 is a schematic diagram showing a distribution of a plurality of solar cell strings in a solar photovoltaic module provided in embodiments of the present disclosure;
FIG. 2 is a schematic diagram showing a first structure of a single solar cell string provided in embodiments of the present disclosure;
FIG. 3 is a partial enlarged view of position A in FIG. 2;
FIG. 4 is an exploded schematic diagram of a monofacial photovoltaic module provided in embodiments of the present disclosure;
FIG. 5 is a schematic diagram showing a second structure of a single solar cell string provided in embodiments of the present disclosure;
FIG. 6 is a schematic diagram showing a third structure of a single solar cell string provided in embodiments of the present disclosure;
FIG. 7 is a schematic diagram showing a fourth structure of a single solar cell string provided in embodiments of the present disclosure; and
FIG. 8 is a schematic diagram showing a structure where two adjacent sub-cells are connected through a solder ribbon, provided in embodiments of the present disclosure.

Reference numerals: 10-solar photovoltaic module; 11-backsheet; 12-back adhesive film; 13-power generation unit; 14-front adhesive film; 15-glass; 100-cell string; 110-sub-cell; 111-non-cut edge; 112-cut edge; 120-solder ribbon; 121-overlapping-area solder ribbon; 122-non-overlapping-area solder ribbon; a-extending direction of solar cell string.

### DETAILED DESCRIPTION OF EMBODIMENTS

To make the purposes, technical solutions, and advantages of the embodiments of the present disclosure clearer, the technical solutions in the embodiments of the present disclosure will be clearly and completely described below with reference to the drawings in the embodiments of the present disclosure. Obviously, the described embodiments are part of the embodiments of the present disclosure, rather than all the embodiments. Generally, the components of the embodiments of the present disclosure described and shown in the drawings herein can be arranged and designed in various different configurations.

Therefore, the following detailed description of the embodiments of the present disclosure provided in the drawings is not intended to limit the scope of the claimed present disclosure, but merely represents selected embodiments of the present disclosure. Based on the embodiments of the present disclosure, all other embodiments obtained by those skilled in the art without making creative efforts shall fall within the protection scope of the present disclosure.

It should be noted that similar reference numerals and letters represent similar items in the following drawings. Therefore, once an item is defined in a drawing, it does not need to be further defined and explained in subsequent drawings.

In the description of the present disclosure, it should be noted that an orientation or positional relationship indicated by the term such as "upper", "lower", "inner", "outer", is based on an orientation or positional relationship shown in the drawings, or an orientation or positional relationship in which the product of the present disclosure is customarily placed during use, which is only for the convenience of describing the present disclosure and simplifying the description, rather than indicating or implying that the referred device or element must have a specific orientation, be constructed and operated in a specific orientation, and thus cannot be understood as a limitation to the present disclosure.

In the description of the present disclosure, it should also be noted that unless otherwise clearly specified and limited, the terms such as "arrange", "install", "link", and "connect" should be interpreted broadly. For example, the term "connection" may be a fixed connection, a detachable connection, or an integral connection; may be a direct connection, or an indirect connection through an intermediate medium; may be an internal communication between two elements. For those of ordinary skill in the art, the specific meanings of the above terms in the present disclosure may be understood according to specific situations.

Since existing improvement measures for enhancing the power generation efficiency of photovoltaic modules all have certain defects, the inventors have found through research that sub-cells are usually obtained by cutting, and accordingly, each sub-cell has at least one cut edge, which results in a large number of cut edges existing in solar photovoltaic modules at the same time. However, due to damage, cut edges are difficult to effectively utilize solar energy for power generation. If the adverse impact of the existence of cut edges on power generation efficiency can be reduced as much as possible, the power generation efficiency of photovoltaic modules can be improved without adjusting the structure of the solar cells themselves or the circuit structure of photovoltaic modules, and there are also advantages such as a short research and development cycle and a low research and development cost.

A solar photovoltaic module of the present disclosure is specifically described below.

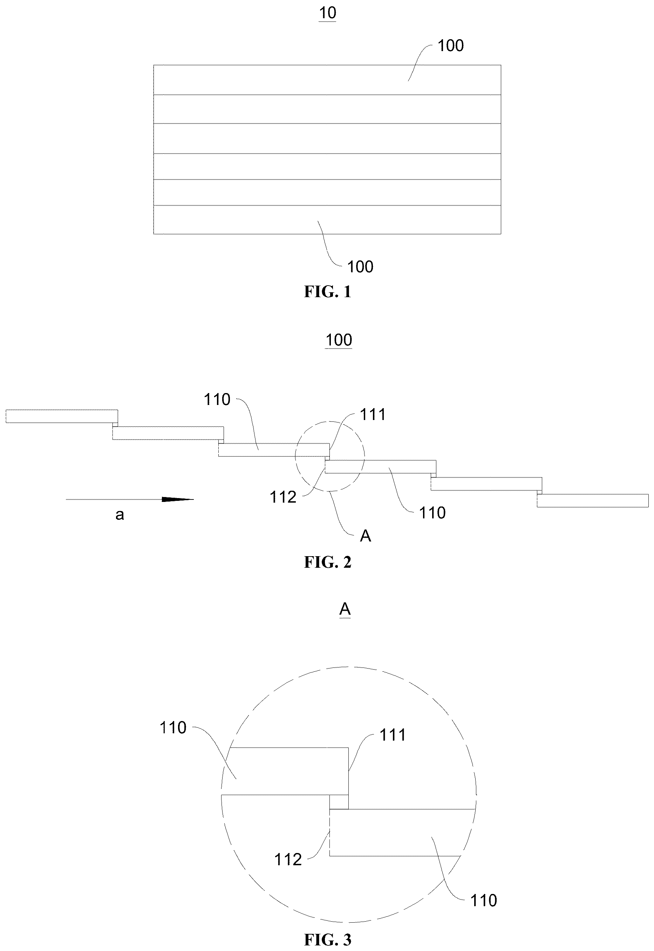

Referring to FIGS. 1 to 3, embodiments of the present disclosure provide a solar photovoltaic module 10. The solar photovoltaic module 10 includes a plurality of solar cell strings 100. Each solar cell string 100 includes a plurality of sub-cells 110 whose edges are sequentially shingled and electrically connected. The sub-cells 110 are obtained by cutting an entire solar cell. In an extending direction a of the solar cell string, for two adjacent sub-cells 110, a non-cut edge 111 of a previous sub-cell 110 is located above a cut edge 112 of a subsequent sub-cell 110, and the non-cut edge 111 of the previous sub-cell 110 is located on a light-receiving side of the photovoltaic module. Moreover, since there is no need to adjust the structure of the solar cell itself or the circuit structure of the photovoltaic module, the solar photovoltaic module 10 with this structure also has advantages such as a short research and development cycle and a low research and development cost.

To better understand the technical solution, a supplementary explanation of the meanings of the cut edge and the non-cut edge is provided here.

Taking non-destructive cutting as an example, the general process is as follows. A laser beam is used to irradiate the solar cell, so that an irradiated area melts and cools rapidly to achieve the cutting effect, thereby obtaining the plurality of cut sub-cells 110. The cut edge 112 refers to a damaged side formed after the solar cell is in direct contact with the laser beam during the cutting process of the entire solar cell. Correspondingly, the non-cut edge 111 refers to a side that is not in direct contact with the laser beam, and generally refers to side edges corresponding to two ends of the entire solar cell.

In the present disclosure, in the extending direction a of the solar cell string, for two adjacent sub-cells 110, the non-cut edge 111 of the previous sub-cell 110 is arranged above the cut edge 112 of the subsequent sub-cell 110, and the non-cut edge 111 is arranged on the light-receiving side of the photovoltaic module. This specific shingling method is able to hide the cut edge 112 which has lower solar energy utilization efficiency on a back of the photovoltaic module, thereby reducing the adverse impact of the existence of the cut edge 112 on the power generation efficiency of the photovoltaic module to a certain extent, and thus improving the power generation efficiency of the photovoltaic module.

It should be noted that the specific type of the solar photovoltaic module 10 is not limited. For example, the solar photovoltaic module 10 may be a monofacial photovoltaic module, a bifacial photovoltaic module, or a flexible photovoltaic module. In other words, there are many specific applicable types of the solar photovoltaic module 10, which can provide many implementable solutions, thereby facilitating the promotion and application of the technical solutions provided in the embodiments of the present disclosure. In the embodiments of the present disclosure, the solar photovoltaic module 10 is taken as a monofacial photovoltaic module for illustration.

To better understand the technical solution, an auxiliary explanation is provided here with reference to a structural schematic diagram of the monofacial photovoltaic module.

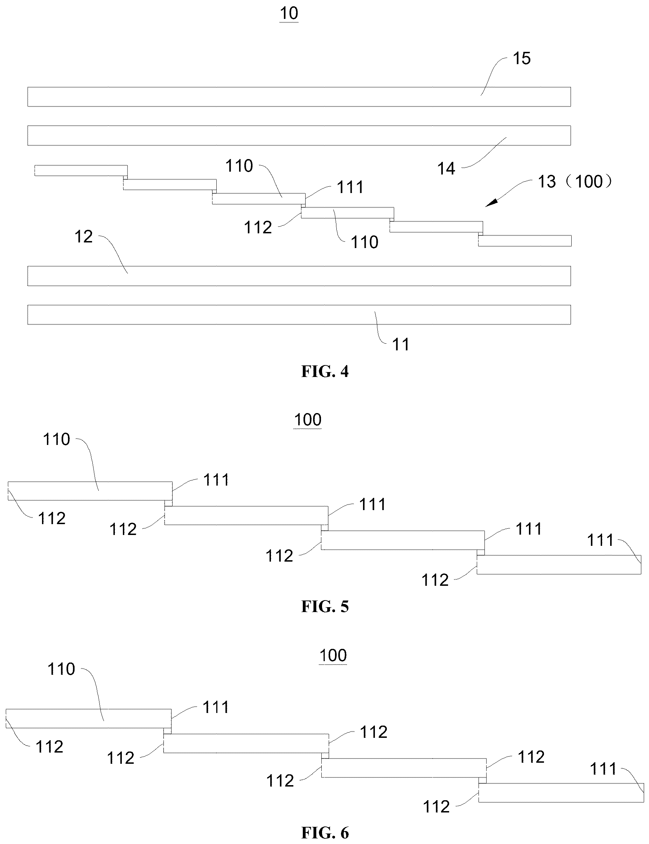

Referring to FIG. 4, as an example, the solar photovoltaic module 10 includes a backsheet 11, a back adhesive film 12, a power generation unit 13, a front adhesive film 14, and glass 15 that are sequentially shingled. The power generation unit 13 is formed by combining the plurality of solar cell strings 100 in series and/or parallel, and the light-receiving side of the solar photovoltaic module 10 is a side where the glass 15 is located.

It should be noted that the specific connection method of the plurality of solar cell strings 100 is not limited, and can be adjusted adaptively according to actual needs.

It should be noted that the type of the solar cell is not limited. For example, the solar cell may be TOPCon, HJT, BC, or PERC.

It should be noted that since there are many cutting methods for the solar cell, such as cutting one entire solar cell into two parts, three parts, four parts, or five parts, the sizes and shapes of the sub-cells 110 obtained by different cutting methods are slightly different. Considering the power generation efficiency after shingling, the cutting methods may be described by classification. Specifically, according to the number of cut edges 112 and the number of non-cut edges 111 of the sub-cells 110 after cutting, the cutting methods may be divided into two categories, i.e., cutting one entire solar cell into two parts, and cutting one entire solar cell into more than two parts.

Referring to FIG. 5, as an example, in a single solar cell string 100, each of a plurality of sub-cells 110 has a cut edge 112 and a non-cut edge 111. In the extending direction a of the solar cell string, for any two adjacent sub-cells 110, a non-cut edge 111 of a previous sub-cell 110 is located above a cut edge 112 of a subsequent sub-cell 110.

In this implementation, the plurality of sub-cells 110 in the same solar cell string 100 each have a cut edge 112 and an opposite non-cut edge 111. That is, the plurality of sub-cells 110 are all obtained through the specific cutting method of cutting one entire solar cell into two parts. On this basis, for any two adjacent sub-cells 110, the non-cut edge 111 of the previous sub-cell 110 is arranged above the cut edge 112 of the subsequent sub-cell 110, so that the cut edges 112 of all the sub-cells 110 (except for a first sub-cell) in the entire photovoltaic module are all located on the back of the photovoltaic module. That is, only the non-cut edges 111 of the sub-cells 110 participate in solar photovoltaic power generation, so that the corresponding photovoltaic module has high power generation efficiency.

Referring to FIG. 6, as an example, in a single solar cell string 100, a sub-cell 110 has a cut edge 112 and a non-cut edge 111, or a sub-cell 110 has two cut edges 112. In the extending direction a of the solar cell string, at least one of a first sub-cell and a last sub-cell of the solar cell string 100 has a cut edge 112 and a non-cut edge 111.

It should be noted that "a sub-cell 110 having a cut edge 112 and a non-cut edge 111" and "a sub-cell 110 having two cut edges 112 without a non-cut edge" represent two different forms of sub-cells 110 after the solar cell is cut. In the cutting methods where one entire solar cell is cut into more than two parts, the sub-cells 110 exist in both forms.

In this implementation, the plurality of sub-cells 110 in the same solar cell string 100 have two different forms, i.e., a sub-cell 110 has one cut edge 112, or a sub-cell 110 has two cut edges 112. That is, the corresponding plurality of sub-cells 110 are obtained through the cutting methods such as cutting one entire solar cell into three parts, four parts, or five parts. For these specific cutting methods, in the same entire solar cell, except that the sub-cells 110 cut from the two ends of the entire solar cell each have a cut edge 112 and a non-cut edge 111, all sub-cells 110 cut from other positions each have two cut edges 112 without a non-cut edge 111. On this basis, in the extending direction a of the solar cell string, by arranging at least one of the first sub-cell and the last sub-cell of the solar cell string 100 to have a cut edge 112 and a non-cut edge 111, the number of cut edges 112 on the light-receiving side of the photovoltaic module is able to be reduced, thereby effectively improving the power generation efficiency of the photovoltaic module.

Referring to FIG. 6, as an example, in the extending direction a of the solar cell string, the first sub-cell and the last sub-cell of the solar cell string 100 each have a cut edge 112 and a non-cut edge 111.

In this implementation, based on the sub-cells 110 obtained through the cutting methods such as cutting one entire solar cell into three parts, four parts, or five parts, in the extending direction a of the solar cell string, both the first sub-cell and the last sub-cell of the solar cell string 100 are arranged to have a cut edge 112 and a non-cut edge 111. That is, the sub-cells 110 with two cut edges 112 and no non-cut edge 111 are all arranged in an inner area of the corresponding solar cell string 100, which is able to further reduce the number of cut edges 112 on the light-receiving side of the photovoltaic module, thereby more effectively improving the power generation efficiency of the photovoltaic module.

It should be noted that under normal circumstances, in a case where there is no problem of solar cell cutting damage (i.e., in a case where all sub-cells 110 cut from an entire solar cell are able to be used normally), N sub-cells 110 obtained by cutting the same entire solar cell are combined into a solar cell unit. Correspondingly, the number of sub-cells 110 in each solar cell unit corresponds to the cutting method (for example, when the cutting method is cutting one entire solar cell into N parts, the number of sub-cells 110 in each solar cell unit is N). Then, the solar cell string 100 can be obtained by sequentially shingling edges of the plurality of solar cell units. The specific number of solar cell units is not limited, and can be adjusted according to the required length of the solar cell string 100.

As an example, each solar cell string 100 includes a plurality of solar cell units whose edges are sequentially shingled and electrically connected. Each solar cell unit includes N sub-cells 110 whose edges are sequentially shingled and electrically connected, where N is a positive integer that is greater than or equal to 3 (N≥3). In at least some of the solar cell units, a first sub-cell and a last sub-cell each have a cut edge 112 and a non-cut edge 111, and N-2 sub-cells 110 between the first sub-cell and the last sub-cell each have two cut edges 112.

In this implementation, for the sub-cells 110 obtained through the cutting method of cutting one entire solar cell into N parts, some of the solar cell units are arranged in a specific form, i.e., the first sub-cell and the last sub-cell each have a cut edge 112 and a non-cut edge 111, and the N-2 sub-cells 110 in the middle each have two cut edges 112 without a non-cut edge 111, which is able to reduce the number of cut edges on the light-receiving side of the photovoltaic module, thereby effectively improving the power generation efficiency of the photovoltaic module.

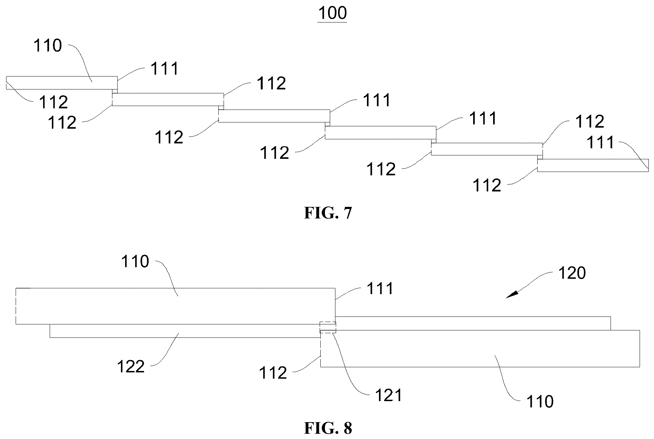

Referring to FIG. 7, as an example, each solar cell unit (not shown in the figure) includes three sub-cells 110 whose edges are sequentially shingled and electrically connected. In at least some of the solar cell units, a first sub-cell and a last sub-cell each have a cut edge 112 and a non-cut edge 111, and a sub-cell 110 between the first sub-cell and the last sub-cell has two cut edges 112.

It should be noted that the configuration where "in at least some of the solar cell units, the first sub-cell and the last sub-cell each have a cut edge 112 and a non-cut edge 111, and the sub-cell 110 between the first sub-cell and the last sub-cell has two cut edges 112" is considered in view of an extreme problem of solar cell cutting damage that may occur during cutting, which makes it impossible to ensure that the three sub-cells 110 in each solar cell unit are all from the same entire solar cell.

In this implementation, for the sub-cells 110 obtained through the cutting method of cutting one entire solar cell into three parts, some of the solar cell units are arranged in a specific form, i.e., the first sub-cell and the last sub-cell each have a cut edge 112 and a non-cut edge 111, and the sub-cell 110 in the middle has two cut edges 112 without a non-cut edge 111, which is able to reduce the number of cut edges 112 on the light-receiving side of the photovoltaic module, thereby effectively improving the power generation efficiency of the photovoltaic module.

Referring to FIG. 7, as an example, in each solar cell unit, the first sub-cell and the last sub-cell each have a cut edge 112 and a non-cut edge 111, and the sub-cell 110 between the first sub-cell and the last sub-cell has two cut edges 112.

It should be noted that the configuration where "in each solar cell unit, the first sub-cell and the last sub-cell each have a cut edge 112 and a non-cut edge 111, and the sub-cell 110 between the first sub-cell and the last sub-cell has two cut edges 112" is considered in view of an ideal state where there is no solar cell cutting damage during cutting, so that the three sub-cells 110 in each solar cell unit are all from the same entire solar cell.

In this implementation, for the sub-cells 110 obtained through the cutting method of cutting one entire solar cell into three parts, all the solar cell units are arranged such that the first sub-cell and the last sub-cell each have a cut edge 112 and a non-cut edge 111, and the sub-cell 110 in the middle has two cut edges 112 without a non-cut edge 111. This shingling method is able to further reduce the number of cut edges 112 on the light-receiving side of the photovoltaic module, thereby more effectively improving the power generation efficiency of the photovoltaic module.

For the sub-cells 110 obtained through the cutting method of cutting one entire solar cell into four parts, compared with the cutting method of cutting one entire solar cell into three parts, in each solar cell unit, the number of sub-cells 110 with two cut edges 112 and no non-cut edge 111 between a first sub-cell and a last sub-cell increases from one to two.

For the sub-cells 110 obtained through the cutting method of cutting one entire solar cell into five parts, compared with the cutting method of cutting one entire solar cell into three parts, in each solar cell unit, the number of sub-cells 110 with two cut edges 112 and no non-cut edge 111 between a first sub-cell and a last sub-cell increases from one to three.

It should be noted that in the extending direction a of the solar cell string, a dimension of an overlapping area of two adjacent sub-cells 110 is not limited, and can be adjusted according to actual needs.

As an example, in each solar cell string 100, in the extending direction a of the solar cell string, a dimension of an overlapping area of any two adjacent sub-cells 110 is in a range of 0.1 mm to 1 mm, for example, but is not limited to, any point value among 0.1 mm, 0.2 mm, 0.3 mm, 0.4 mm, 0.5 mm, 0.6 mm, 0.7 mm, 0.8 mm, 0.9 mm, and 1 mm, or any range value between any two of these values.

In this implementation, the overlapping area of any two adjacent sub-cells 110 is limited to a specific range, which is able to well balance the manufacturing cost and power generation efficiency (generally, a smaller overlapping area leads to a higher manufacturing cost. However, if the overlapping area is too large, the light-receiving area is decreased, which in turn reduces the power generation efficiency).

It should be noted that in the extending direction a of the solar cell string, the electrical connection method between two adjacent sub-cells 110 is not limited. For example, two adjacent sub-cells 110 may be connected by a solder ribbon 120 or a conductive adhesive.

Referring to FIG. 8, as an example, in the extending direction a of the solar cell string, any two adjacent sub-cells 110 are electrically connected through a solder ribbon 120.

In this implementation, any two adjacent sub-cells 110 are electrically connected through the solder ribbon 120, which has advantages such as firm connection, good electrical conductivity, and ease of industrial manufacturing.

It should be noted that a solder ribbon 120 corresponding to the overlapping area and a solder ribbon 120 in the non-overlapping area may be integrally formed (e.g., a complete round-wire solder ribbon 120), or the solder ribbon 120 corresponding to the overlapping area can be adjusted according to specific needs.

Referring to FIG. 8, as an example, in the extending direction a of the solar cell string, the solder ribbon 120 includes an overlapping-area solder ribbon 121 located in the overlapping area and a non-overlapping-area solder ribbon 122 located outside the overlapping area. A thickness of the overlapping-area solder ribbon 121 is less than a thickness of the non-overlapping-area solder ribbon 122, and a width of the overlapping-area solder ribbon 121 is greater than a width of the non-overlapping-area solder ribbon 122.

In this implementation, the thickness of the overlapping-area solder ribbon 121 is set to be less than the thickness of the non-overlapping-area solder ribbon 122, and the width of the overlapping-area solder ribbon 121 is set to be greater than the width of the non-overlapping-area solder ribbon 122, i.e., the overlapping-area solder ribbon 121 is thinned and widened, which is conducive to improving the electrical conductivity while improving the mechanical strength after connection.

It should be noted that the specific size, material, and shape of the solder ribbon 120 to which each area corresponds are not limited, and can be adjusted according to actual needs.

As an example, the thickness of the overlapping-area solder ribbon 121 is in a range of 70 µm to 110 µm, for example, but is not limited to, any point value among 70 µm, 80 µm, 90 µm, 100 µm, and 110 µm, or any range value between any two of these values.

As an example, the non-overlapping-area solder ribbon 122 is a round-wire solder ribbon 120, and a diameter of the non-overlapping-area solder ribbon 122 is in a range of 0.18 mm to 0.22 mm, for example, but is not limited to, any point value among 0.18 mm, 0.19 mm, 0.20 mm, 0.21 mm, and 0.22 mm, or any range value between any two of these values.

It should be noted that for the structures or functional units of the solar photovoltaic module 10 that are not specifically described or limited, they can be set according to conventional choices in the field.

The above descriptions are merely preferred embodiments of the present disclosure, and are not intended to limit the present disclosure. For those skilled in the art, various modifications and changes can be made to the present disclosure. Any modification, equivalent replacement, improvement, etc., made within the spirit and principles of the present disclosure shall be included in the protection scope of the present disclosure.

## Claims

1. A solar photovoltaic module, **characterized by** comprising:
a plurality of solar cell strings, wherein each solar cell string comprises a plurality of sub-cells whose edges are sequentially shingled and electrically connected, and the sub-cells are obtained by cutting an entire solar cell; and in an extending direction of the solar cell string, for two adjacent sub-cells, a non-cut edge of a previous sub-cell is located above a cut edge of a subsequent sub-cell, and the non-cut edge of the previous sub-cell is located on a light-receiving side of the photovoltaic module.

2. The solar photovoltaic module according to claim 1, wherein in a single solar cell string, the plurality of sub-cells each have one cut edge and one non-cut edge; and in an extending direction of the solar cell string, for any two adjacent sub-cells, a non-cut edge of a previous sub-cell is located above a cut edge of a subsequent sub-cell.

3. The solar photovoltaic module according to claim 1, wherein in a single solar cell string, a sub-cell has either one cut edge and one non-cut edge or two cut edges; and in an extending direction of the solar cell string, at least one of a first sub-cell and a last sub-cell of the solar cell string has one cut edge and one non-cut edge.

4. The solar photovoltaic module according to claim 3, wherein in the extending direction of the solar cell string, the first sub-cell and the last sub-cell of the solar cell string each have one cut edge and one non-cut edge.

5. The solar photovoltaic module according to claim 4, wherein each solar cell string comprises a plurality of solar cell units whose edges are sequentially shingled and electrically connected, and each solar cell unit comprises N sub-cells whose edges are sequentially shingled and electrically connected, where N is a positive integer that is greater than or equal to 3; and in at least some of the solar cell units, a first sub-cell and a last sub-cell each have one cut edge and one non-cut edge, and N-2 sub-cells between the first sub-cell and the last sub-cell each have two cut edges.

6. The solar photovoltaic module according to claim 5, wherein each solar cell unit comprises three sub-cells whose edges are sequentially shingled and electrically connected; and in at least some of the solar cell units, the first sub-cell and the last sub-cell each have one cut edge and one non-cut edge, and a sub-cell between the first sub-cell and the last sub-cell has two cut edges.

7. The solar photovoltaic module according to claim 6, wherein in each solar cell unit, the first sub-cell and the last sub-cell each have one cut edge and one non-cut edge, and the sub-cell between the first sub-cell and the last sub-cell has two cut edges.

8. The solar photovoltaic module according to any one of claims 1 to 7, wherein the solar photovoltaic module is a monofacial photovoltaic module or a bifacial photovoltaic module.

9. The solar photovoltaic module according to any one of claims 1 to 7, wherein in each solar cell string, in the extending direction of the solar cell string, a dimension of an overlapping area of any two adjacent sub-cells is in a range of 0.1 mm to 1 mm.

10. The solar photovoltaic module according to any one of claims 1 to 7, wherein in the extending direction of the solar cell string, any two adjacent sub-cells are electrically connected through a solder ribbon; and in the extending direction of the solar cell string, the solder ribbon comprises an overlapping-area solder ribbon located in an overlapping area and a non-overlapping-area solder ribbon located outside the overlapping area, wherein a thickness of the overlapping-area solder ribbon is less than a thickness of the non-overlapping-area solder ribbon, and a width of the overlapping-area solder ribbon is greater than a width of the non-overlapping-area solder ribbon.
